# EUROPÄISCHE PATENTANMELDUNG

(11) **EP 1 432 297 A2**
(43) Veröffentlichungstag der Anmeldung: **23.06.2004**
(21) Anmeldenummer: 03104215.3
(22) Anmeldetag: 17.11.2003
(51) Int. Cl.: H05K 9/00

(54) **Flachbaugruppe**

(30) Priorität: 20.12.2002 DE 10260255
(71) Anmelder: Siemens Aktiengesellschaft, 80333 München (DE)
(72) Erfinder: Hünting, Ralf, 46395, Bocholt (DE)

(57) **Zusammenfassung**

Damit Flachbaugruppen z.B. für hochfrequenztechnische Anwendungen kostengünstig realisierbar sind wird vorgeschlagen, die Flachbaugruppe (1) in einen separaten nicht hochfrequenztechnischen und einen separaten hochfrequenztechnischen Flachbaugruppenteil (2; 3) mit jeweiliger zugehöriger Leiterplatte (4; 5) als Trägerplatte für jeweilige elektronische Bauelemente (7) zu unterteilen und aus diesen unterteilten Flachbaugruppenteilen (2,3) zusammen zu setzen. Ferner wird vorgeschlagen, die jeweiligen Trägerplatten wenigstens jeweils mit einem Erdungsflächenbereich auszustatten, wobei zumindest Teile der Erdungsflächenbereiche der Flachbaugruppenteile (2; 3) im zusammengesetzten Zustand der Flachbaugruppe (1) zueinander überlappend platziert sind. Weiter wird vorgeschlagen, elektronische Bauelemente (7) des einen und/oder anderen Flachbaugruppenteils (2; 3) im Bereich der überlappend platzierten Erdungsflächenbereiche zwischen den überlappend platzierten Erdungsflächenbereichen zu positionieren und elektronische Bauelemente als Abstandshalter und/oder elektrische Verbindungsstegteile (8) mit Abstandshalterfunktion zwischen den Trägerplatten vorzusehen.

## Beschreibung

Die Erfindung betrifft eine Flachbaugruppe gemäß dem Oberbegriff des Anspruchs 1.

Flachbaugruppen, die aus mehreren Flachbaugruppenteilen zusammengesetzt sind und die mit elektrischen Verbindungsteilen wie beispielsweise Kontaktleisten, zum Beispiel gemäß dem Dokument DE 3738051 A1, zwecks einer elektrischen Kontaktierung zwischen den einzelnen Flachbaugruppenteilen ausgestattet sind, sind teuer und aufwendig in der Montage. Außerdem benötigen sie sehr viel Raum.

In der Hochfrequenztechnik, beispielsweise auf dem Gebiet der Kommunikationsendgeräte, sind Flachbaugruppen eingesetzt, die zwar einen hochfrequenztechnischen Teil aufweisen, aber eben nicht ausschließlich hochfrequenztechnische Teile haben. Da an die hochfrequenztechnischen Teile hohe technische Anforderungen zu stellen sind, ist es sinnvoll, diejenigen Teile, die nicht hochfrequenztechnischen Funktionen dienen, in einfacheren Strukturen herzustellen, um dadurch die Kosten zu senken. Eine in einem solchen Fall verwendete Flachbaugruppe kann daher in einen hochfrequenztechnischen und einen nicht hochfrequenztechnischen Flachbaugruppenteil unterteilt sein, wobei die Flachbaugruppenteile mittels elektrischer Verbindungselemente elektrisch miteinander verbunden sind.

Eine Aufteilung einer Flachbaugruppe in mehrere Flachbaugruppenteile, die dann mittels elektrischer Verbindungselemente miteinander zur Bildung der vollständigen Flachbaugruppe verbunden werden, ist jedoch, wie oben schon angedeutet, nicht zwangsläufig auf hochfrequenztechnische Anwendungen beschränkt. Diese Methode kann vielmehr überall dort eingesetzt werden, wo Flachbaugruppen verwendet werden, die elektrisch funktionierende Teile haben, an die höhere Anforderungen zu stellen sind als an andere. Es müssen dann nicht jeweils alle Teile mit den Anforderungen gefertigt werden, die die höchsten Anforderungen darstellen.

Um bei dem Beispiel der Hochfrequenztechnik zu bleiben ist es nicht notwendig, z.B. die als Trägerplatte für die nicht hochfrequenztechnischen Bauteile dienende Leiterplatte in der selben aufwendigen Weise herzustellen wie die als Trägerplatte für die hochfrequenztechnischen Bauteile dienende Leiterplatte. Da außerdem der nicht hochfrequenztechnischen Zwecken dienende Teil einer Flachbaugruppe in der Regel der größere Teil ist, kann auf diese Weise die Flachbaugruppe insgesamt wesentlich billiger produziert werden. Auf der anderen Seite kann auf Grund einer solchen Einsparung der hochfrequenztechnische Teil zur weiteren Verbesserung seiner technischen Funktionalität in einer entsprechend aufwendigeren Technik gefertigt werden.

Ein Nachteil insbesondere von hochfrequenztechnischen Modulen ist oft, dass sie mit teuren metallischen Abschirmhauben abgeschirmt werden müssen. Solche Abschirmhauben sind allein für sich teuer und verlangen zudem eine aufwendige Montagemethode.

Nach der voneinander unabhängigen Fertigung der einzelnen Flachbaugruppenteile können die Flachbaugruppenteile zu der gewünschten Flachbaugruppe zusammengesetzt werden. Hierbei kann beispielsweise der hochfrequenztechnische Flachbaugruppenteil huckepack auf den nicht hochfrequenztechnischen Flachbaugruppenteil montiert werden.

Nachteilig bei einer solchen Huckepack-Montage ist, dass die Höhe der sich dabei ergebenden Flachbaugruppe relativ hoch ist. Bei dem heutigen Bestreben, die Geräte immer mehr zu miniaturisieren, spielt die Höhe einer verwendeten Flachbaugruppe eine entscheidende Rolle.

Eine Möglichkeit, die Höhe solcher Flachbaugruppen zu reduzieren, ist, beispielsweise das in der Regel kleinere hochfrequenztechnische Flachbaugruppenteil auf den Kopf gestürzt auf das restliche Flachbaugruppenteil zu montieren, wobei die hochfrequenztechnischen Bauelemente gegebenenfalls mit ihrer metallischen Abschirmhaube durch eine Aussparung in dem restlichen Flachbaugruppenteil ragen. Auf diese Weise kann wenigstens eine Leiterplattendicke eingespart werden.

Nachteilig dabei ist, dass nach wie vor eine metallische Abschirmhaube verwendet werden muss. Weiter nachteilig ist, dass in dem nicht hochfrequenztechnischen Flachbaugruppenteil eine Montageaussparung vorgesehen ist, durch die dieser Teil verteuert und zusätzlich auch für Bauteile verkleinert ist. In dem Bereich der Aussparung können keine Schaltungsbauelemente platziert werden. Schließlich ist nachteilig, dass der Gesamtmontageaufwand erhöht ist, weil das Einbringen und Einpassen des auf den Kopf gestürzten hochfrequenztechnischen Flachbaugruppenteils entsprechend kompliziert ist.

Aufgabe der Erfindung ist es, ausgehend von einer Flachbaugruppe der eingangs genannten Art eine Flachbaugruppe anzugeben, die kostengünstig ist und auch kostengünstig, das heißt einfach, zu fertigen ist.

Diese Aufgabe wird erfindungsgemäß durch eine Flachbaugruppe gelöst, die die Merkmale des Anspruchs 1 aufweist.

Eine solche Flachbaugruppe hat den Vorteil, dass bei Bedarf einer Abschirmung für z.B. hochfrequenztechnische Bauelemente eine solche Abschirmung ohne teure eigenständige metallische Abschirmhaube realisierbar ist. Ein anderer Vorteil ist, dass eine Aussparung in einem der Flachbaugruppenteile nicht notwendig ist. Ein weiterer Vorteil ist, dass eine einfache Zusammenmontage der Flachbaugruppenteile gegeben ist. Ein weiterer Vorteil ist, dass unterhalb des hochfrequenztechnischen Flachbaugruppenteils elektronische Bauelemente anbringbar sind. Vorteilhaft ist ferner, dass eine Miniaturisierung von ca. 7% gegenüber bisherigen Methoden erzielbar ist. Vorteilhaft ist auch, dass ein zusätzlicher Pastendruck entfallen kann. Er kann entfallen, weil eine Bestückung von Bauteileseite zu Bauteileseite erfolgt. Außerdem kann die Leiterplattentechnologie sehr leicht von 4 Lagen auf 2 Lagen angepasst werden, wodurch Kosten reduziert werden. Dies ist möglich, weil die unterste Lage bei der Leiterplatte, die normalerweise für eine "Verdrahtung" zur Basisleiterplatte genutzt wird, nicht benötigt wird. Die Verbindung geschieht, wie gesagt, von der Bauteileseite zur Bauteileseite. Schließlich können spezielle Bauteile beispielsweise für die Bildung einer Schnittstelle zwischen den einzelnen Flachbaugruppenteilen entfallen.

Vorteilhafte Ausgestaltungen der Erfindung sind Gegenstand von Unteransprüchen.

Danach wird die Abstandshaltung bzw. die Verbindungsstegbereitstellung mit Abstandshaltungsfunktion zwischen den Flachbaugruppenteilen durch elektronische Bauelemente gebildet, die entweder regulär funktionierende elektronische Bauelemente oder praktisch kostenlos zur Verfügung stehende Schüttgutbauelemente sind. Schüttgutbauelemente können insbesondere in Form von elektronischen Ausschussbauelementen vorliegen, die in einer Fertigung zahlreich anfallen und die auf diese Weise noch nutzdienlich verwendbar sind. Es sind auch einfachste, aus elektrisch leitendem Material bestehende Stanzteile verwendbar.

Die elektrisch leitende Verbindung zwischen den Flachbaugruppenteilen ergibt sich aus der elektrisch leitenden Brücke, die diese Bauteile zwischen den Flachbaugruppenteilen bilden. Steckerleisten zum Beispiel für eine solche Verbindung können entfallen. Die Montage der betreffenden Teile erfolgt im gleichen Arbeitsgang, in dem auch alle anderen elektronischen Bauteile montiert werden. Der Abstand zwischen den Flachbau gruppenteilen wird durch die Höhe der verwendeten Bauteile bestimmt, die in der Größenordnung aller anderen elektronischen Bauteile liegt. Dieser Abstand bestimmt damit in entscheidender Weise die Gesamthöhe der Flachbaugruppe, die somit wesentlich geringer ist als bei der Verwendung herkömmlicher Verbindungsstecker. Mit Wegfall der herkömmlichen Verbindungsstecker reduziert sich auch der Preis in entsprechender Weise. Eine Abschirmung für bestimmte Bauelemente kann automatisch dadurch bewerkstelligt werden, dass in den jeweiligen Leiterplatten der jeweiligen Flachbaugruppen eine metallische, geerdete Lage vorhanden ist, die sich gegenseitig wenigstens zum Teil überlappen. Innerhalb des Überlappungsbereichs können die entsprechenden elektronischen Bauteile auf den jeweiligen Leiterplatten der Flachbaugruppenteile platziert werden, wobei sie dann von einer oberen und einer unteren Seite her abgeschirmt sind.

Nachfolgend wird die Erfindung anhand einer Zeichnung näher erläutert. Darin zeigen:
- Figur 1: eine Flachbaugruppe für hochfrequenztechnische Anwendungen gemäß dem Stand der Technik,
- Figur 2: eine Flachbaugruppe für hochfrequenztechnische Anwendungen gemäß der Erfindung, und
- Figur 3: eine vergrößerte Darstellung eines Teils der Flachbaugruppe gemäß der Figur 2.

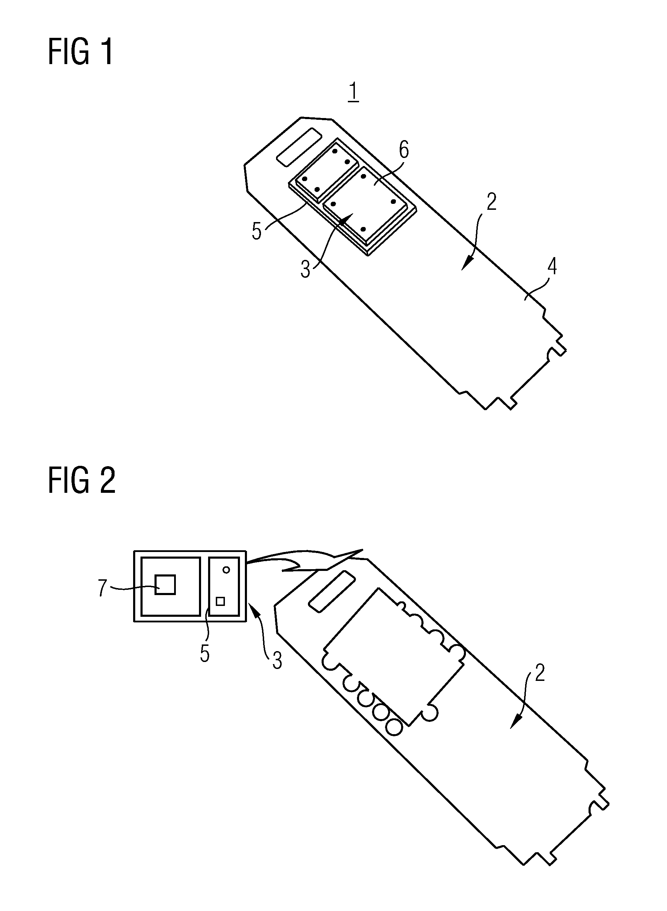

In der Figur 1 ist eine Flachbaugruppe 1 für hochfrequenztechnische Anwendungen dargestellt, die aus einem ersten Flachbaugruppenteil 2 und einem zweiten Flachbaugruppenteil 3 besteht. Das erste Flachbaugruppenteil 2 umfasst alles, was den nicht hochfrequenztechnischen Teil der Flachbaugruppe 1 ausmacht. Der zweite Flachbaugruppenteil 3 umfasst alles, was den hochfrequenztechnische Teil der Flachbaugruppe 1 ausmacht.

Die einzelnen Flachbaugruppenteile 2, 3 sind in der Figur 1 lediglich stilisiert dargestellt. Einzelheiten sind auf den Flachbaugruppenteilen 2, 3 nicht zu sehen.

Basis für ein jeweiliges Flachbaugruppenteil 2, 3 ist eine Leiterplatte 4, 5, die jeweilig als Trägerplatte für jeweilige zugehörige elektronische Bauelemente dient.

Zur Bildung der Flachbaugruppe 1 sind die beiden die Flachbaugruppe 1 ausmachenden Flachbaugruppenteile 2, 3 in der Weise zusammengesetzt, dass das hochfrequenztechnische Flachbaugruppenteil 3 huckepack auf dem nicht hochfrequenztechnische Flachbaugruppenteil 2 montiert ist. Das hochfrequenztechnische Flachbaugruppenteil 3 ist dabei auf die Bauteileseite des nicht hochfrequenztechnischen Flachbaugruppenteils 2 montiert. Hierbei ist die Lötseite des hochfrequenztechnischen Flachbaugruppenteils 3 der Bauteileseite des nicht hochfrequenztechnischen Flachbaugruppenteils 2 zugewandt. Zur Abschirmung der hochfrequenztechnischen Bauelemente des hochfrequenztechnischen Flachbaugruppenteils 3 weist das hochfrequenztechnische Flachbaugruppenteil 3 eine Abschirmhaube 6 auf.

In der Figur 2 sind die Flachbaugruppenteile 2, 3 voneinander gelöst dargestellt. Außerdem handelt es sich bei dem in der Figur 2 dargestellten hochfrequenztechnischen Flachbaugruppenteil 3 um ein gemäß der Erfindung modifiziertes Teil. Dieses Teil wird auf das nicht hochfrequenztechnische Flachbaugruppenteil 2 mit der Bauteileseite nach unten, wie durch einen stilisierten Pfeil angedeutet, montiert. Das Flachbaugruppenteil 3 der Figur 2 weist keine Abschirmhaube zum Abschirmen der auf der Leiterplatte 5 des Flachbaugruppenteils 3 angeordneten elektronischen Bauelemente 7 auf. Die Abschirmung ergibt sich bei einer derartigen Montage automatisch dadurch, dass die elektronischen Bauelemente 7 in der Höhe gesehen zwischen Erdungsflächenbereichen der Leiterplatten 4, 5 der Flachbaugruppenteile 2, 3, die solche Erdungsflächenbereiche haben, zu liegen kommen.

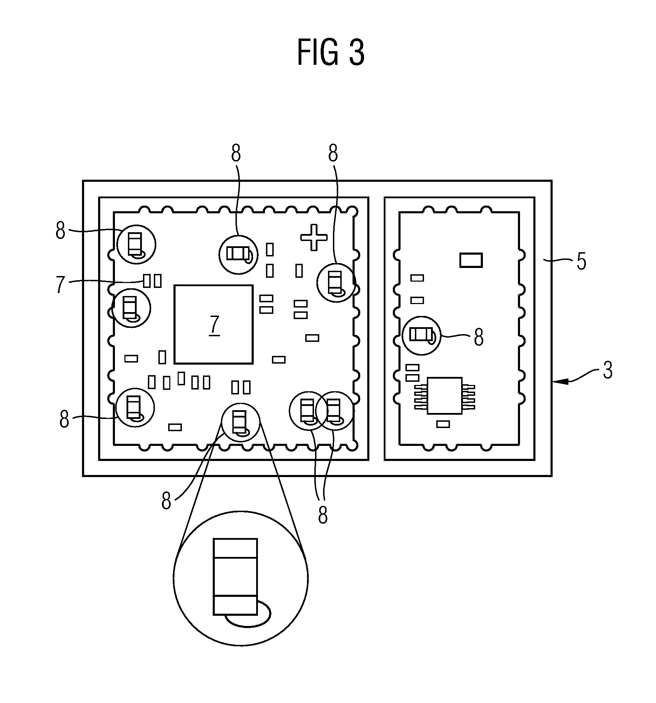

Die elektrische und mechanische Verbindung zwischen den beiden Flachbaugruppenteilen 2, 3 erfolgt über elektronische Bauelemente (Figur 3), die als Abstandshalter und/oder als Verbindungsstegteile 8 wirken. Bei diesen Bauelementen handelt es sich von der Grundstruktur her um die gleichen Bauelemente, wie sie für die übrige Schaltung eingesetzt sind. Im vorliegenden Ausführungsbeispiel handelt es sich um SMD-Bauelemente. Diese Bauelemente können, wie schon gesagt, eine rein mechanische oder eine elektrische und mechanische Funktion haben. In besonderer Weise aber nicht ausschließlich bieten sich hierzu Kondensator- oder Widerstandsbauelemente an. In der Regel haben diese Bauelemente eine Höhe, die erlaubt, zwischen den Leiterplatten 4, 5 der Flachbaugruppenteile 2, 3 noch andere elektronische Bauelemente beispielsweise für die Realisierung der eigentlichen elektronischen Schaltung anzuordnen. Dabei erfolgt die Befestigung der angesprochenen Bauelemente 8 in gleicher Weise und vorteilhafterweise im gleichen Zug wie die übrigen elektronischen Bauelemente 7.

## Patentansprüche

1. Flachbaugruppe, die aus mehreren Flachbaugruppenteilen zusammengesetzt ist, die miteinander elektrisch leitend verbunden sind, **dadurch gekennzeichnet, dass** die elektrisch leitende Verbindung durch wie elektronische Bauelemente (7) montierbare Abstandshalter und/oder elektrische Verbindungsstegteile (8) mit Abstandshalterfunktion gebildet sind, dass die Flachbaugruppenteile (2; 3) gegeneinander jeweils bauteileseitig angeordnet sind und dass die wie elektronische Bauelemente montierbaren Abstandshalter und/oder elektrischen Verbindungsstegteile (8) mit Abstandshalterfunktion gleichzeitig Bauteil der jeweiligen Flachbaugruppenteile (2; 3) der Flachbaugruppe (1) für eine elektrisch leitende Verbindung zwischen den Flachbaugruppenteilen (2; 3) sind.

2. Flachbaugruppe nach Anspruch 1, **dadurch gekennzeichnet, dass** ein nicht hochfrequenztechnisches Flachbaugruppenteil (2) und ein hochfrequenztechnisches Flachbaugruppenteil (3) vorhanden ist mit jeweilig zugehörigen Leiterplatten (4, 5) als eine jeweilige Trägerplatte für jeweilige elektronische Bauelemente (7), dass die jeweiligen Trägerplatten wenigstens jeweils einen Erdungsflächenbereich haben, dass die Erdungsflächenbereiche im zusammengesetzten Zustand der Flachbaugruppe (1) gegeneinander zumindest in Teilbereichen überlappend platziert sind, dass elektronische Bauelemente (7) des einen und/oder anderen Flachbaugruppenteils (2; 3) innerhalb des sich überlappenden Erdungsflächenbereichs angeordnet sind.

3. Flachbaugruppe nach Anspruch 1 oder 2, **dadurch gekennzeichnet, dass** aktive hochfrequenztechnische elektronische Bauelemente (7) innerhalb des sich überlappenden Erdungsflächenbereichs angeordnet sind und dass wenigstens zum Teil die wie elektronische Bauelemente montierbaren Abstandshalter und/oder elektrischen Verbindungsstegteile (8) mit Abstandshalterfunktion als ein elektronisches Bauelement ausgebildet sind.

4. Flachbaugruppe nach einem der vorherigen Ansprüche, **dadurch gekennzeichnet, dass** wenigstens ein einziges der als Abstandshalter bzw. Verbindungsstegteile (8) dienenden Bauelemente ein innerhalb der Gesamtschaltung der Flachbaugruppe (1) aktiv verwendetes elektronisches Bauelement ist.

5. Flachbaugruppe nach einem der vorherigen Ansprüche, **dadurch gekennzeichnet, dass** wenigstens ein einziges der wie elektronische Bauelemente montierbaren Abstandshalter und/oder elektrischen Verbindungsstegteile (8) mit Abstandshalterfunktion ein Schüttgutbauelement ist.

6. Flachbaugruppe nach einem der vorherigen Ansprüche, **dadurch gekennzeichnet, dass** die wie elektronische Bauelemente montierbaren Abstandshalter und/oder elektrischen Verbindungsstegteile (8) mit Abstandshalterfunktion SMD-Bauelemente sind.
